# EUROPEAN PATENT APPLICATION

(11) **EP 3 885 775 A1**
(43) Date of publication of application: **29.09.2021**
(21) Application number: 20165967.9
(22) Date of filing: 26.03.2020
(51) Int. Cl.: G01R 31/28, G01R 31/26, G01R 29/22, G01N 3/32, B06B 1/06

(54) **SYSTEM FOR ACCELERATING THE AGEING OF INTERCONNECTIONS USED FOR INTERCONNECTING POWER SEMICONDUCTORS**

(71) Applicant: Mitsubishi Electric R & D Centre Europe B.V., 1119 NS Schiphol Rijk (NL); Mitsubishi Electric Corporation, Tokyo 100-8310 (JP)
(72) Inventor: DEGRENNE, Nicolas, 35708 RENNES Cedex 7 (FR); OUHAB, Merouane, 35708 RENNES Cedex 7 (FR); MOLLOV, Stefan, 35708 RENNES Cedex 7 (FR)
(74) Representative: Cabinet Le Guen Maillet

(57) **Abstract**

The present invention concerns a system for accelerating the ageing of interconnections used for interconnecting power semiconductors. The system comprises:
- a piezoelectric material,
- at least one interconnection used for interconnecting power semiconductors located on the top and/or the bottom of the piezoelectric material,
-means for applying an electric field between the top and the bottom of the piezoelectric material using a first electrode disposed on the top of the piezoelectric material and a second electrode disposed on the bottom of the piezoelectric material,
- means for measuring the behaviour of the at least one interconnection used for interconnecting power semiconductors.

## Description

### TECHNICAL FIELD

The present invention relates generally to a system for accelerating the ageing of interconnections used for interconnecting power semiconductors.

### RELATED ART

Understanding the effect of mechanical stress on the strength and the lifetime of interconnections in power semiconductor devices is necessary to face the high requirements in terms of reliability level. Mechanical testing plays an important role in the design stage of power semiconductors and even after the manufacturing of the power semiconductor. Mechanical testing of interconnections enables to measure and improve reliability and robustness of the interconnection, reduce qualification tests, optimize designs for specific performances and develop physics-based lifetime models.

Wire bond lift-off and die solder cracking are pointed out as the most recurrent degradation processes under field conditions due to thermomechanical fatigue.

The dissipated losses during operation flow through the multi-layers of the power semiconductor assembly and are extracted by means of the heatsink.

This causes temperature gradients inside the multi-layered structure. The mismatch in the Coefficient of Thermal Expansion (CTE) of the stacked layers generates high shear stresses at interfaces, which induce voids formation and cracks propagation in wire bonds and die solder joints. Consequently, the losses increase and the thermal path degrades causing an overheating in the power semiconductor zone leading to more accumulated damage over the time until the device failure.

Thermal cycling is a testing method, where the temperature of the whole device under test package is isothermally cycled using a climatic room temperature. The applied thermal cycle lasts usually for many minutes. This test emulates the variation of ambient temperature.

### SUMMARY OF THE INVENTION

The present invention aims to provide a system for accelerating the ageing of interconnections used for interconnecting power semiconductors.

To that end, the present invention concerns a system for accelerating the ageing of interconnections used for interconnecting power semiconductors, characterized in that the system comprises:
- a piezoelectric material,
- at least one interconnection used for interconnecting power semiconductors located on the top and/or the bottom of the piezoelectric material,
- means for applying an electric field between the top and the bottom of the piezoelectric material using a first electrode disposed on the top of the piezoelectric material and a second electrode disposed on the bottom of the piezoelectric material. Since the electrodes will not be tested for ageing, they must be more reliable compared to the interconnections used for interconnecting power semiconductors. To achieve it:
- means for measuring the behaviour of the least one interconnection used for interconnecting power semiconductors.

Thus, the interconnection(s) can be subjected to an ageing process by electromechanical dilatation using a cyclic electric field instead of using power cycling tests that are energy consuming and present high cost.

According to a particular feature, the interconnection used for interconnecting power semiconductors is composed of a metallization on which a wire or a foil or a ribbon is bonded.

Thus, it is possible to replicate the wire/foil/ribbon-metallization structure found in standard power devices, and therefore to generate similar interface stress profile. Moreover, the metallization allows to apply a uniform electric field within the piezoelectric material.

According to a particular feature, it further comprises a third electrode that is connected to the wire or the foil or the ribbon and means for monitoring the resistance between the first and third electrodes.

Thus, the third electrode allows an on-line measurement of the interconnection resistance that is correlated to the degradation level of the contact between the wire/foil/ribbon and the metallization.

According to a particular feature, the interconnection used for interconnecting power semiconductors is a solder or a sintering joint.

Thus, standard solders (Sn-Ag-Cu alloys) or advanced die attaches based on sintering can be tested to measure their reliability, since they are considered as critical regions in standard power devices.

According to a particular feature, it further comprises a third electrode that is connected to the solder or the sintering joint and means for monitoring the resistance between the second and third electrodes.

Thus, it allows to monitor the degradation of the solder or the sintering joint based on the resistance as an electrical indicator.

According to a particular feature, the system comprises two interconnections used for interconnecting power semiconductors. A first interconnection located on the top of the piezoelectric element is composed of a metallization on which a wire or a foil or a ribbon is bonded and a second interconnection located on the bottom of the piezoelectric element is a solder or a sintering joint.

Thus, it is possible to conduct an ageing test for both critical interconnections in power devices at the same time, i.e. top and bottom interconnections. Here, it is possible to study under which conditions one of the interconnections is more prone to degradation and failure (or lifetime limited) than the other.

According to a particular feature, the system comprises:
- at least two piezoelectric materials having the same properties,
- at least one interconnection used for interconnecting power semiconductors located on the top and/or the bottom of the piezoelectric materials,
- means for applying an electric field between the top and the bottom of each piezoelectric material separately, the electric field being different of the electric field applied between the top and the bottom of at least one other piezoelectric material,
- means for measuring the behaviour of the least one interconnection used for interconnecting power semiconductors.

According to a particular feature, no electric field is applied between the first and second electrodes of one piezoelectric material during a given time and the first and second electrodes are used for measuring the voltage across said piezoelectric material in order to estimate the local effective strain during the given time.

Thus, it is possible to control fully the strain-stress profile generated over the surface of the piezoelectric material. Therefore, a specific ageing profile can be applied to test the targeted interconnection(s).

According to a particular feature, the system comprises:
- at least two piezoelectric materials having different properties,
- at least one interconnection used for interconnecting power semiconductors located on the top and/or the bottom of the piezoelectric materials,
- means for applying an electric field between the top and the bottom of each piezoelectric material using one electrode disposed on the top of the piezoelectric materials and the electrode disposed on the bottom of the piezoelectric materials,
- means for measuring the behaviour of the at least one interconnection used for interconnecting power semiconductors.

According to a particular feature, the system is further mounted on a ceramic base plate.

Thus, it would be possible to reproduce the same multi-layered stack that can be found in standard power devices and modules. In addition, the ceramic offers an electrical isolation and a mechanical stability.

The present invention concerns also a method for accelerating the ageing of interconnections used for interconnecting power semiconductors, characterized in that the method comprises the steps of:
- disposing one interconnection used for interconnecting power semiconductors located on the top and/or the bottom of a piezoelectric material,
- applying an electric field between the top and the bottom of the piezoelectric material using a first electrode disposed on the top of the piezoelectric material and a second electrode disposed on the bottom of the piezoelectric material,
- measuring the behaviour of the at least one interconnection used for interconnecting power semiconductors.

Thus, the interconnection(s) can be subjected to an ageing process by electromechanical dilatation using a cyclic electric field instead of using power cycling tests that are energy consuming and present high cost.

According to a particular feature, the method further comprises the steps of:
- coating, prior applying the electrical field, in a resin the interconnection used for interconnecting power semiconductors located on the top and/or the bottom of a piezoelectric material and the piezoelectric material,
- cutting, prior applying the electrical field, on a vertical axis the interconnection used for interconnecting power semiconductors located on the top and/or the bottom of the piezoelectric material and the piezoelectric material,
- removing the resin prior applying the electrical field,
and the measuring of the behaviour of the at least one interconnection used for interconnecting power semiconductors is performed using a Digital Image Correlation method, Scanning Acoustic Microscopy or crystallography.

Thus, this technique allows a close monitoring of crack propagation in the interconnections from one side based on a cross-section that preserves its electrical functionality. Crack conditions might be monitored using for example a Digital Image Correlation (DIC) method, Scanning Acoustic Microscopy (SAM) or crystallography to analyse the microstructure change with the ageing process.

### BRIEF DESCRIPTION OF THE DRAWINGS

The characteristics of the invention will emerge more clearly from a reading of the following description of example embodiments, the said description being produced with reference to the accompanying drawings, among which:
Fig. 1 represents a first example of a system for accelerating the ageing of interconnections used for interconnecting power semiconductors according to the present invention;
Fig. 2 represents a second example of a system for accelerating the ageing of interconnections used for interconnecting power semiconductors according to the present invention;
Fig. 3 represents a third example of a system for accelerating the ageing of interconnections used for interconnecting power semiconductors according to the present invention;
Fig. 4 represents a fourth example of a system for accelerating the ageing of interconnections used for interconnecting power semiconductors according to the present invention;
Fig. 5 represents a fifth example of a system for accelerating the ageing of interconnections used for interconnecting power semiconductors according to the present invention and for measuring the behaviour of the at least one interconnection used for interconnecting power semiconductors;
Fig. 6 represents a sixth example of a system for accelerating the ageing of interconnections used for interconnecting power semiconductors according to the present invention and for measuring the behaviour of the at least one interconnection used for interconnecting power semiconductors;
Fig. 7 represents a device that is able to execute the method disclosed in reference of Fig. 8.
Fig. 8 represents an example of an algorithm for accelerating the ageing of interconnections used for interconnecting power semiconductors according to the present invention and for measuring the behaviour of the at least one interconnection used for interconnecting power semiconductors;
Figs. 9 represent an example of views of a system for accelerating the ageing of interconnections used for interconnecting power semiconductors provided by the algorithm of Fig. 8;
Fig. 10 represents a seventh example of a system for accelerating the ageing of interconnections used for interconnecting power semiconductors according to the present invention;
Fig. 11 represents an eighth example of a system for accelerating the ageing of interconnections used for interconnecting power semiconductors according to the present invention.

### DESCRIPTION

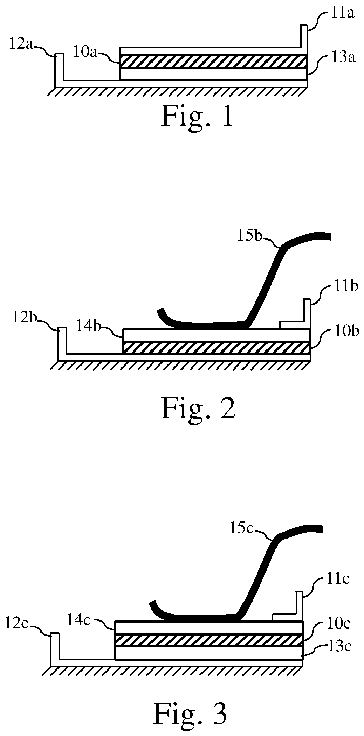

**Fig. 1** represents a first example of a system for accelerating the ageing of interconnections used for interconnecting power semiconductors according to the present invention.

The system comprises a piezoelectric material 10a, an interconnection 13a used for interconnecting power semiconductors located on the bottom of the piezoelectric material 10a. The interconnection 13a used for interconnecting power semiconductors is a solder or a sintered joint.

In one example of implementation, the interconnection 13a is a conductive joint including at least a Sn-Ag-Cu (SAC) alloy with a thickness comprised between 10 µm and 500 µm.

The system comprises a first electrode 11a disposed on the top of the piezoelectric material 10a and a second electrode 12a disposed on the bottom of the piezoelectric material 10a that are used for applying an electric field between the top and the bottom of the piezoelectric material 10a.

In order to improve the reliability of the first and second electrodes, the electrodes metallization can be designed using a specific material (Nickel, Silver ... etc.), thickness and/or pattern. The first and second electrodes may also be spring-loaded in order to provide a reliable contact with the piezoelectric material.

The electric field is for example a square, triangular sinusoidal or a sawtooth waveform.

The electric field may be also a time dependent profile which reproduces complex mechanical loading.

**Fig. 2** represents a second example of a system for accelerating the ageing of interconnections used for interconnecting power semiconductors according to the present invention.

The system comprises a piezoelectric material 10b, an interconnection used for interconnecting power semiconductors located on the top of the piezoelectric material 10b. The interconnection used for interconnecting power semiconductors is composed of a metallization 14b on which a wire or a foil or a ribbon 15b is bonded.

The interconnection is for example composed of a cylindrical aluminium wire with a diameter comprised between 50 µm and 800 µm. The wire is bonded onto the metallization that is made of aluminium with a thickness less than 10 µm.

The system comprises a first electrode 11b disposed on the top of the metallization 14b and a second electrode 12b disposed on the bottom of the piezoelectric material 10b that are used for applying an electric field between the top and the bottom of the piezoelectric material 10b.

In order to improve the reliability of the first and second electrodes, the electrodes metallization can be designed using a specific material (Nickel, Silver ... etc.), thickness and/or pattern. The first and second electrodes may be also be spring-loaded in order to provide a reliable contact with the piezoelectric material.

The electric field is for example a square, triangular, sinusoidal or a sawtooth waveform.

The electric field may be also a time dependent profile which reproduces complex mechanical loading.

**Fig. 3** represents a third example of a system for accelerating the ageing of interconnections used for interconnecting power semiconductors according to the present invention.

The system comprises a piezoelectric material 10c and two interconnections 13c and 15b used for interconnecting power semiconductors.

The interconnection 13c is used for interconnecting power semiconductors located on the bottom of the piezoelectric material 10c. The interconnection 13c used for interconnecting power semiconductors is a solder or a sintering joint.

The interconnection 13c is a conductive joint including at least a Sn-Ag-Cu (SAC) alloy with a thickness comprised between 10 µm and 500 µm.

The system comprises a first electrode 11c disposed on the top of the piezoelectric material 10c and a second electrode 12c disposed on the bottom of the piezoelectric material 10c that are used for applying an electric field between the top and the bottom of the piezoelectric material 10c.

In order to improve the reliability of the first, second and third electrodes, the electrodes metallization can be designed using a specific material (Nickel, Silver ...etc.), thickness and/or pattern. The first and second electrodes may also be spring-loaded in order to provide a reliable contact with the piezoelectric material.

The electric field is for example a square, triangular, sinusoidal or a sawtooth waveform.

The electric field may be also a time dependent profile which reproduces complex mechanical loading.

The interconnection used for interconnecting power semiconductors is composed of a metallization 14c on which a wire or a foil or a ribbon 15c is bonded and is disposed on the top of the piezoelectric material 10c.

The interconnection 15c is for example composed of a cylindrical aluminium wire with a diameter comprised between 50 µm and 800 µm. The wire is bonded onto the metallization that is made of aluminium with a thickness less than 10 µm.

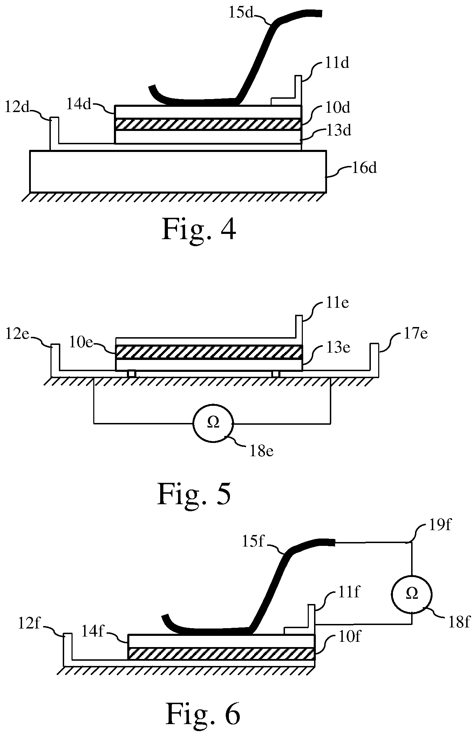

**Fig. 4** represents a fourth example of a system for accelerating the ageing of interconnections used for interconnecting power semiconductors according to the present invention.

The system comprises a piezoelectric material 10d, an interconnection 13d used for interconnecting power semiconductors located on the bottom of the piezoelectric material 10d. The interconnection 13d used for interconnecting power semiconductors is a solder or a sintering joint.

The interconnection 13d is a conductive joint including at least a Sn-Ag-Cu (SAC) alloy with a thickness comprised between 10 µm and 500 µm.

The system comprises a first electrode 11d disposed on the top of the piezoelectric material 10d and a second electrode 12d disposed on the bottom of the piezoelectric material 10d that are used for applying an electric field between the top and the bottom of the piezoelectric material 10d.

In order to improve the reliability of the first and second electrodes, the electrodes metallization can be designed using a specific material (Nickel, Silver ... etc.), thickness and/or pattern. The first and second electrodes may also be spring-loaded in order to provide a reliable contact with the piezoelectric material.

The electric field is for example a square, triangular, sinusoidal or a sawtooth waveform.

The electric field may also be a time dependent profile which reproduces complex mechanical loading.

The system further comprises a ceramic base plate (16d) on which the second electrode 12d is mounted. The baseplate is made of Alumina (Al2O3)- or Aluminium Nitride (AlN)-based ceramic with a thickness higher than 700 um.

The ceramic baseplate is used to provide a mechanical stability for the assembly during the fatigue test, it reproduces more accurately the structure of a power module, and thus, the strain/stress is also more realistically reproduced on the wire and/or the solder/sintered layer.

It has to be noted here that the ceramic baseplate may be replaced by a direct bonded copper (*DBC*) substrate.

**Fig. 5** represents a fifth example of a system for accelerating the ageing of interconnections used for interconnecting power semiconductors according to the present invention and for measuring the behaviour of the at least one interconnection used for interconnecting power semiconductors.

The system comprises a piezoelectric material 10e, an interconnection 13e used for interconnecting power semiconductors located on the bottom of the piezoelectric material 10e. The interconnection 13e used for interconnecting power semiconductors is a solder or a sintering joint.

The interconnection 13e is a conductive joint including at least a Sn-Ag-Cu (SAC) alloy with a thickness comprised between 10 µm and 500 µm.

The system comprises a first electrode 11e disposed on the top of the piezoelectric material 10e, a second electrode 12e disposed on the bottom of the piezoelectric material 10e that are used for applying an electric field between the top and the bottom of the piezoelectric material 10e.

In order to improve the reliability of the first and second electrodes, the electrodes metallization can be designed using a specific material (Nickel, Silver ... etc.), thickness and/or pattern. The first and second electrodes may also be spring-loaded in order to provide a reliable contact with the piezoelectric material.

The electric field is for example a square, triangular, sinusoidal or a sawtooth waveform.

The electric field may be also a time dependent profile which reproduces complex mechanical loading.

The system further comprises a third electrode 17e that is connected to the solder or the sintering joint and means 18e for monitoring the resistance between the second and third electrodes.

**Fig. 6** represents a sixth example of a system for accelerating the ageing of interconnections used for interconnecting power semiconductors according to the present invention and for measuring the behaviour of the at least one interconnection used for interconnecting power semiconductors.

The system comprises a piezoelectric material 10f, an interconnection 13f used for interconnecting power semiconductors located on the top of the piezoelectric material 10f. The interconnection used for interconnecting power semiconductors is composed of a metallization 14f on which a wire or a foil or a ribbon 15f is bonded.

The interconnection is for example composed of a cylindrical aluminium wire with a diameter comprised between 50 µm and 800 µm. The wire is bonded onto the metallization that is made of aluminium with a thickness less than 10 µm.

The system comprises a first electrode 11f disposed on the top of the metallization 14b and a second electrode 12f disposed on the bottom of the piezoelectric material 10f that are used for applying an electric field between the top and the bottom of the piezoelectric material 10f.

In order to improve the reliability of the first and second electrodes, the electrodes metallization can be designed using a specific material (Nickel, Silver ... etc.), thickness and/or pattern. The first and second electrodes may also be spring-loaded in order to provide a reliable contact with the piezoelectric material.

The electric field is for example a square, triangular, sinusoidal or a sawtooth waveform.

The electric field may be also a time dependent profile which reproduces complex mechanical loading.

The system further comprises a third electrode 19f that is connected to the wire or the foil or the ribbon 15f and means 18f for monitoring the resistance between the first and third electrodes.

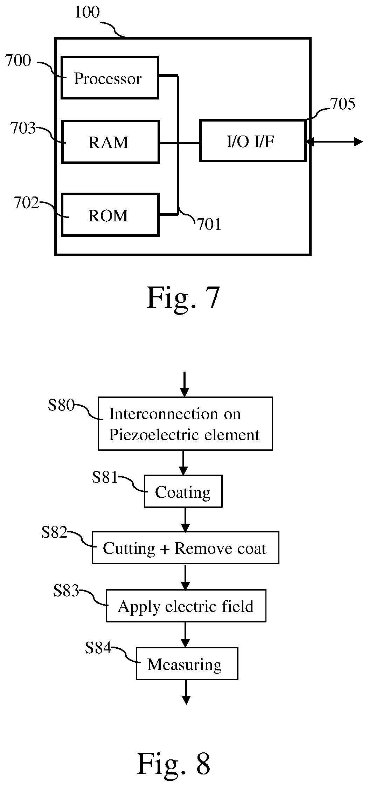

**Fig. 7** represents a device that is able to execute the method disclosed in reference of Fig. 8.

The device 100 has, for example, an architecture based on components connected together by a bus 701 and a processor 700 controlled by a program.

The bus 701 links the processor 700 to a read only memory ROM 702, a random access memory RAM 703, and an input output I/O interface I/F 705.

The memory 703 contains registers intended to receive variables and the instructions of the program related to the algorithm disclosed in Fig. 8.

The read-only memory, or possibly a flash memory 702, contains instructions of the program related to the algorithm disclosed in Fig. 8.

When the device 100 is powered on, the instructions stored in the memory 702 are transferred to the random access memory 703.

In other words, the device 100 includes circuitry enabling the estimation module 107 to perform the program as disclosed in Fig. 8.

**Fig. 8** represents an example of an algorithm for accelerating the ageing of interconnections used for interconnecting power semiconductors according to the present invention and for measuring the behaviour of the at least one interconnection used for interconnecting power semiconductors.

At step S80, the device 100 commands through the input output I/O interface I/F 705 the disposing of two interconnections used for interconnecting power semiconductors located on the tops 14g and 15g and on the bottom 13g of the piezoelectric material 10g.

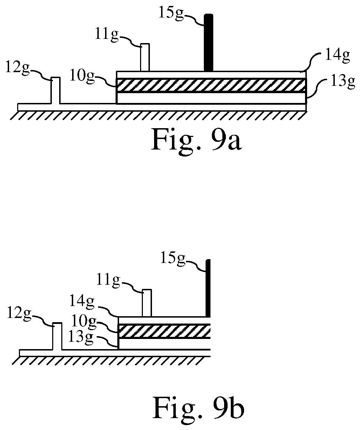

At step S81, the device 100 commands through the input output I/O interface I/F the coating in a resin of the interconnections 13g and 15g used for interconnecting power semiconductors located on the top and the bottom of a piezoelectric material and the piezoelectric material 10g as shown in Fig. 9a.

At step S82, the device 100 commands through the input output I/O interface I/F to perform a micro-section of the interconnection used for interconnecting power semiconductors as disclosed in Fig. 9b. For that, the device 100 commands through the input output I/O interface I/F to cut on a vertical axis the interconnection used for interconnecting power semiconductors located on the top and/or the bottom of the piezoelectric material and the piezoelectric material. At the same step, the device 100 commands through the input output I/O interface I/F the removing of the resin using, for example, dedicated chemicals.

At step S83, the device 100 commands through the input output I/O interface I/F the applying, during a predetermined period, of an electric field between the top and the bottom of the piezoelectric material using a first electrode 11g disposed on the top of the piezoelectric material and a second electrode 12g disposed on the bottom of the piezoelectric material 10g.

At step S84, the device 100 commands through the input output I/O interface I/F a Digital Image Correlation system and/or a Scanning Acoustic Microscopy system or crystallography analysis system in order to measure the behaviour of the least one interconnection used for interconnecting power semiconductors.

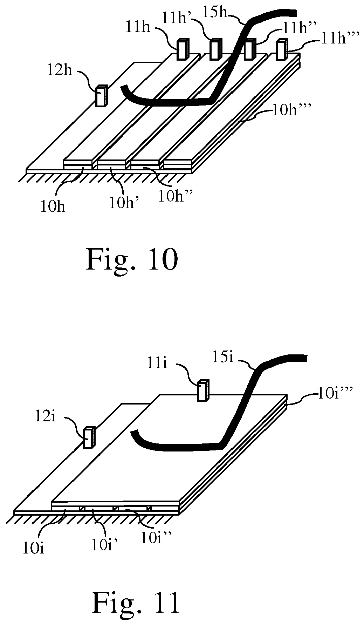

**Fig. 10** represents a seventh example of a system for accelerating the ageing of interconnections used for interconnecting power semiconductors according to the present invention.

The system comprises plural piezoelectric materials 10h, 10h', 10h" and 10h'", one interconnection used for interconnecting power semiconductors located on the top of the piezoelectric materials 10h, 10h', 10h" and 10h'". The piezoelectric materials have the same piezoelectric property. The interconnection used for interconnecting power semiconductors is composed of metallization 14h, 14h', 14h" and 14h'" on which a wire or a foil or a ribbon 15h is bonded.

The system comprises for each piezoelectric material a first electrode 11h, 11h', 11h" and 11h'" disposed on the top of the metallization 14h, 14h', 14h" and 14h'" and a second electrode 12h disposed on the bottom of the piezoelectric material 10h that are used for applying an electric field between the top and the bottom of the piezoelectric materials 10h, 10h', 10h" and 10h"'.

In order to improve the reliability of the electrodes, each electrode metallization can be designed using a specific material (Nickel, Silver ... etc.), thickness and/or pattern. The electrodes may also be spring-loaded in order to provide a reliable contact with the piezoelectric material.

In the example of Fig. 10, the electric field between the top and the bottom of each piezoelectric material is different of the electric field applied between the top and the bottom of at least one other piezoelectric materials.

It has to be noted here that, in a particular mode of realization, no electric field is applied between the first and second electrodes of one piezoelectric material during a given time and the first and second electrodes are used for measuring the voltage across said piezoelectric material in order to estimate the local effective strain during the given time.

**Fig. 11** represents an eighth example of a system for accelerating the ageing of interconnections used for interconnecting power semiconductors according to the present invention.

The system comprises plural piezoelectric materials 10i, 10i', 10i" and 10i'", one interconnection used for interconnecting power semiconductors located on the top of the piezoelectric materials 10h, 10h', 10h" and 10h'". The piezoelectric materials have different piezoelectric properties. The interconnection used for interconnecting power semiconductors is composed of a metallization on which a wire or a foil or a ribbon 15i is bonded.

The system comprises for the piezoelectric materials a first electrode 11i disposed on the top of the metallization and a second electrode 12i disposed on the bottom of the piezoelectric material 10i that are used for applying an electric field between the top and the bottom of the piezoelectric materials 10i, 10i', 10i" and 10i"'.

In order to improve the reliability of the first and second electrodes, the electrodes metallization can be designed using a specific material (Nickel, Silver ... etc.), thickness and/or pattern. The first and second electrodes may also be spring-loaded in order to provide a reliable contact with the piezoelectric material.

In the example of Fig. 11, the electric field between the top and the bottom of each piezoelectric material is the same as the electric field applied between the top and the bottom of the other piezoelectric materials.

Naturally, many modifications can be made to the embodiments of the invention described above without departing from the scope of the present invention.

## Claims

1. A system for accelerating the ageing of interconnections used for interconnecting power semiconductors, **characterized in that** the system comprises:
- a piezoelectric material,
- at least one interconnection used for interconnecting power semiconductors located on the top and/or the bottom of the piezoelectric material,
- means for applying an electric field between the top and the bottom of the piezoelectric material using a first electrode disposed on the top of the piezoelectric material and a second electrode disposed on the bottom of the piezoelectric material,
- means for measuring the behaviour of the at least one interconnection used for interconnecting power semiconductors.

2. The system according to claim 1, **characterized in that** the interconnection used for interconnecting power semiconductors is composed of a metallization layer on which a wire or a foil or a ribbon is bonded.

3. The system according to claim 2, **characterized in that** it further comprises a third electrode that is connected to the wire or the foil or the ribbon and means for monitoring the resistance between the first and third electrodes.

4. The system according to claim 1, **characterized in that** the interconnection used for interconnecting power semiconductors is a solder or a sintered joint.

5. The system according to claim 4, **characterized in that** it further comprises a third electrode that is connected to the solder or the sintered joint and means for monitoring the resistance between the second and third electrodes.

6. The system according to claim 1, **characterized in that** the system comprises two interconnections used for interconnecting power semiconductors, a first interconnection located on the top of the piezoelectric element is composed of a metallization on which a wire or a foil or a ribbon is bonded and a second interconnection located on the bottom of the piezoelectric element is a solder or a sintered joint.

7. The system according to claim 1, **characterized in that** the system comprises:
- at least two piezoelectric materials having the same properties,
- at least one interconnection used for interconnecting power semiconductors located on the top and/or the bottom of the piezoelectric materials,
- means for applying an electric field between the top and the bottom of each piezoelectric material, the electric field being different of the electric field applied between the top and the bottom of the at least one other piezoelectric material,
- means for measuring the behaviour of the at least one interconnection used for interconnecting power semiconductors.

8. The system according to claim 7, **characterized in that** no electric field is applied between the first and second electrodes of one piezoelectric material during a given time and the first and second electrodes are used for measuring the voltage across said piezoelectric material in order to estimate the local effective strain during the given time.

9. The system according to claim 1, **characterized in that** the system comprises:
- at least two piezoelectric materials having different properties,
- at least one interconnection used for interconnecting power semiconductors located on the top and/or the bottom of the piezoelectric materials,
- means for applying an electric field between the top and the bottom of each piezoelectric material using one electrode disposed on the top of the piezoelectric materials and one electrode disposed on the bottom of the piezoelectric materials,
- means for measuring the behaviour of the at least one interconnection used for interconnecting power semiconductors.

10. The system according to any of the claims 1 to 4, **characterized in that** the system is further mounted on a ceramic base plate.

11. A method for accelerating the ageing of interconnections used for interconnecting power semiconductors, **characterized in that** the method comprises the steps of:
- disposing one interconnection used for interconnecting power semiconductors located on the top and/or the bottom of a piezoelectric material,
- applying an electric field between the top and the bottom of the piezoelectric material using a first electrode disposed on the top of the piezoelectric material and a second electrode disposed on the bottom of the piezoelectric material,
- measuring the behaviour of the at least one interconnection used for interconnecting power semiconductors.

12. The method according to claim 10, **characterized in that** the method further comprises the steps of:
- coating, prior applying the electrical field, in a resin the interconnection used for interconnecting power semiconductors located on the top and/or the bottom of a piezoelectric material and the piezoelectric material,
- cutting, prior applying the electrical field, on a vertical axis the interconnection used for interconnecting power semiconductors located on the top and/or the bottom of the piezoelectric material and the piezoelectric material,
- removing the resin prior applying the electrical field,
and the measuring a Digital Image Correlation system and/or a Scanning Acoustic Microscopy system or crystallography analysis system.
